# EUROPEAN PATENT APPLICATION

(11) **EP 4 529 390 A1**
(43) Date of publication of application: **26.03.2025**
(21) Application number: 24192560.1
(22) Date of filing: 02.08.2024
(51) Int. Cl.: H10H 20/857, H10H 20/851

(54) **PACKAGE STRUCTURE**

(30) Priority: 19.09.2023 TW 112135621
(71) Applicant: Lextar Electronics Corp., Hsinchu City 300094 (TW)
(72) Inventor: Lo, Jin-Wen, 300094 Hsinchu City (TW); Tsai, Yun-Jie, 300094 Hsinchu City (TW); Hung, Pin-Feng, 300094 Hsinchu City (TW); Lan, Kuo-Jen, 300094 Hsinchu City (TW); Hsieh, Cheng-Min, 300094 Hsinchu City (TW)
(74) Representative: Ter Meer Steinmeister & Partner

(57) **Abstract**

A package structure is provided. The package structure includes a lead frame, a first connecting piece, a light-emitting diode, an engaging protrusion, and a fluorescent encapsulant. The lead frame has an upper surface, a lower surface, and a side surface between the upper surface and the lower surface. The first connecting piece is disposed at the center of the upper surface. The light-emitting diode is disposed on the first connecting piece. The engaging protrusion is disposed on the periphery of the upper surface. The fluorescent encapsulant is disposed on the upper surface and covers the light-emitting diode and the engaging protrusion.

## Description

This Application claims priority of Taiwan Patent Application No. 112135621, filed on 09/19/2023.

### BACKGROUND OF THE INVENTION

### Field of the Invention

The disclosure is related to a package structure, and in particular, it is related to a package structure having an engaging protrusion.

### Description of the Related Art

With the wide application of electronic devices, people's requirements for them have gradually increased. The package structure used for light-emission, for example, usually includes a light-emitting diode and an encapsulant covering the light-emitting diode. However, after long-term use, the encapsulant may fall off, which leads to device failure. Therefore, although existing electronic devices have largely met their intended uses, they still have problems such as short service life. Therefore, how to provide an electronic device with a long service life has become an urgent issue that needs to be solved.

### BRIEF SUMMARY OF THE INVENTION

Thus it is an object of the invention to provide an electronic device having a long service life.

In some embodiments, a package structure is provided. The package structure includes a lead frame, a first connecting piece, a light-emitting diode, an engaging protrusion, and a fluorescent encapsulant. The lead frame has an upper surface, a lower surface, and a side surface between the upper surface and the lower surface. The first connecting piece is disposed at the center of the upper surface. The light-emitting diode is disposed on the first connecting piece. The engaging protrusion is disposed on the periphery of the upper surface. The fluorescent encapsulant is disposed on the upper surface and covers the light-emitting diode and the engaging protrusion.

In one or more embodiments, the lead frame may have a corner.

In one or more embodiments, the engaging protrusion may be on the corner of the lead frame and/or may extend along two adjacent sides of the lead frame.

In one or more embodiments, the package structure may further comprise a step portion.

In one or more embodiments, the step portion may be between the engaging protrusion and the lead frame.

In one or more embodiments, in a plan view, an area of the step portion may be larger than an area of the engaging protrusion.

In one or more embodiments, the engaging protrusion may have a first through hole.

In one or more embodiments, a part of the fluorescent encapsulant may be in the first through hole.

In one or more embodiments, the step portion may have a second through hole.

In one or more embodiments, a part of the fluorescent encapsulant may be in the second through hole.

In one or more embodiments, the engaging protrusion may have a first through hole, the step portion may have a second through hole, and a part of the fluorescent encapsulant may be in the first through hole and the second through hole.

In one or more embodiments, the lead frame may have one side.

In one or more embodiments, the engaging protrusion may be on the side of the lead frame and extends toward a corner of the lead frame.

In one or more embodiments, the engaging protrusion may be disposed around the lead frame.

In one or more embodiments, a material of the engaging protrusion may be different from a material of the lead frame.

In one or more embodiments, a length, a width, or a height of the engaging protrusion may be greater than 0.1mm.

In one or more embodiments, the light-emitting diode may be a blue LED.

In one or more embodiments, the fluorescent encapsulant may comprise yellow light conversion materials.

In one or more embodiments,the package structure may comprise a white encapsulant disposed on the fluorescent encapsulant.

In one or more embodiments, the lead frame may have a width, the fluorescent encapsulant may have a first thickness, the white encapsulant may have a second thickness, and the sum of the first thickness and the second thickness may be less than or equal to the width.

In one or more embodiments, the fluorescent encapsulant may have a first thickness, the white encapsulant may have a second thickness, and a ratio of the first thickness to the second thickness may be between 3 and 18.

In one or more embodiments,the package structure may further comprise a second connecting piece disposed on the upper surface, and the second connecting piece may be between the engaging protrusion and the first connecting piece.

In one or more embodiments, the package structure may further comprise a supporting piece disposed in the lead frame.

In one or more embodiments, a mechanical strength of the supporting piece may be higher than a mechanical strength of the lead frame.

In one or more embodiments, at least a part of the supporting piece may be on a side of the lead frame adjacent to the upper surface.

In one or more embodiments, the entire supporting piece may be on the side of the lead frame adjacent to the upper surface.

In one or more embodiments, the engaging protrusion may be wavy or stepped in a side view.

The package structure of the disclosure can be applied to various types of electronic devices. In order to make the features and advantages of the disclosure more comprehensible, various embodiments are specially cited below, together with the accompanying drawings, to be described in detail as follows.

### BRIEF DESCRIPTION OF THE DRAWINGS

Aspects of the disclosure are best understood from the following detailed description when read with the accompanying figures. It should be noted that, in accordance with the standard practice in the industry, various features are not drawn to scale. In fact, the dimensions of the various features may be arbitrarily increased or reduced for clarity of discussion.
FIG. 1 is a schematic diagram of the package structure at the formation stage of some embodiments of the disclosure.
FIG. 2A is a top view of the lead frame component of some embodiments of the disclosure.
FIG. 2B is a cross-sectional view along the line A-A' in FIG. 2A.
FIG. 2C a side view of the lead frame component of some embodiments of the disclosure.
FIG. 2D a bottom view of lead frame component of some embodiments of the disclosure.
FIG. 3A is a top view of the lead frame component of other embodiments of the disclosure.
FIG. 3B a side view of the lead frame component of other embodiments of the disclosure.
FIG. 4 is a top view of the lead frame component of other embodiments of the disclosure.
FIG. 5 is a top view of the lead frame component of other embodiments of the disclosure.
FIG. 6 is a top view of the lead frame component of other embodiments of the disclosure.
FIG. 7 is a top view of the lead frame component of other embodiments of the disclosure.
FIG. 8 is a top view of the lead frame component of other embodiments of the disclosure.
FIG. 9A is a top view of the lead frame component of other embodiments of the disclosure.
FIG. 9B a side view of the lead frame component of other embodiments of the disclosure.
FIGS. 10 to 14 are schematic diagrams of the package structure at different formation stages of some embodiments of the disclosure.
FIG. 15 schematic side view of package structure of some embodiments of the disclosure.
FIG. 16 schematic diagram of the backlight module of some embodiments of the disclosure.

### DETAILED DESCRIPTION OF THE INVENTION

The following disclosure provides many different embodiments or examples for implementing the provided package structure. Specific examples of features and their configurations are described below to simplify the embodiments of the disclosure, but certainly not to limit the disclosure. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the disclosure may repeat reference numerals and/or letters in the various examples. This repetition is for the purpose of simplicity and clarity and does not in itself dictate a relationship between the various embodiments and/or configurations discussed.

In some embodiments of the disclosure, terms about disposing and connecting, such as "disposing", "connecting" and similar terms, unless otherwise specified, may refer to two features are in direct contact with each other, or may also refer to two features are not in direct contact with each other, wherein there is an additional connect feature between the two features. The terms about disposing and connecting may also include the case where both features are movable, or both features are fixed.

In addition, ordinal numbers such as "first", "second", and the like used in the specification and claims are configured to modify different features or to distinguish different embodiments or ranges, rather than to limit the number, the upper or lower limits of features, and are not intended to limit the order of manufacture or arrangement of features.

Herein, the terms "approximately", "about", and "substantially" generally mean within 10%, within 5%, within 3%, within 2%, within 1%, or within 0.5% of a given value or range. The given value is an approximate value, that is, "approximately", "about", and "substantially" can still be implied without the specific description of "approximately", "about", and "substantially". The phrase "a range between a first value and a second value" means that the range includes the first value, the second value, and other values in between. Furthermore, any two values or directions used for comparison may have certain tolerance. If the first value is equal to the second value, it implies that there may be a tolerance within about 10%, within 5%, within 3%, within 2%, within 1%, or within 0.5% between the first value and the second value. If the first direction is perpendicular to the second direction, the angle between the first direction and the second direction may be between 80 degrees and 100 degrees. If the first direction is parallel to the second direction, the angle between the first direction and the second direction may be between 0 degrees and 10 degrees.

Unless otherwise defined, all terms (including technical and scientific terms) used herein have the same meaning as commonly understood by one of ordinary skill in the art. It should be understood that these terms, such as those defined in commonly used dictionaries, should be interpreted as having meanings consistent with the background or context of the related technology and the disclosure, and should not be interpreted in an idealized or overly formal manner, unless otherwise specified in the embodiments of the disclosure.

It should be noted that, for clarity of explanation, some features of the device are omitted in the drawings, and only some features are schematically illustrated. In some embodiments, additional components may be added to the electronic device of the disclosure. In some embodiments, some components of the electronic device disclosed herein may be replaced or omitted. In some embodiments, additional processing steps may be provided before, during, and/or after a manufacturing method of an electronic device. In some embodiments, some of the described processing steps may be replaced or omitted, and the order of some of the described processing steps may be interchangeable. Furthermore, it should be understood that some of the described processing steps may be replaced or deleted for other embodiments of the method.

In the prior art, the package structure may include a light-emitting diode (LED) and an encapsulant covering the light-emitting diode. As mentioned above, the encapsulant may detach from the light-emitting diode after being used for a long time or under certain environments (for example, high temperature and high humidity), causing the electronic device including it to fail. To this end, the disclosure provides a package structure that effectively improves the strength of connection between the light-emitting diode and the encapsulant through the lead frame with the specific engaging protrusion. In this way, the disclosure realizes a package structure with high service life.

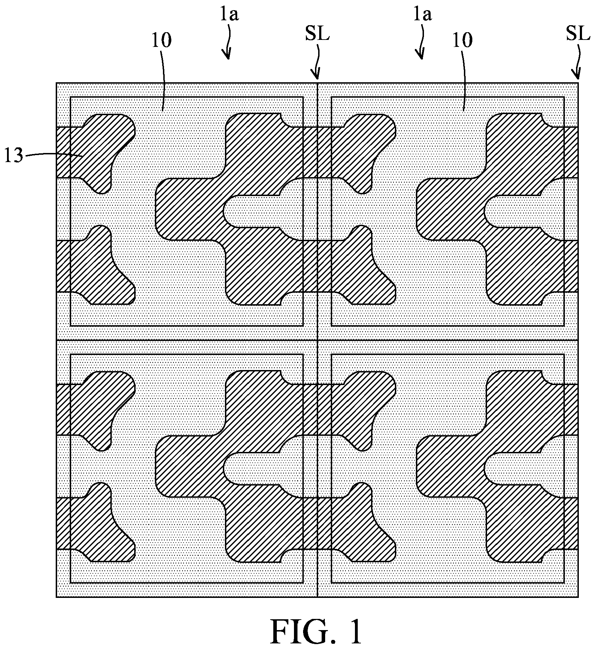

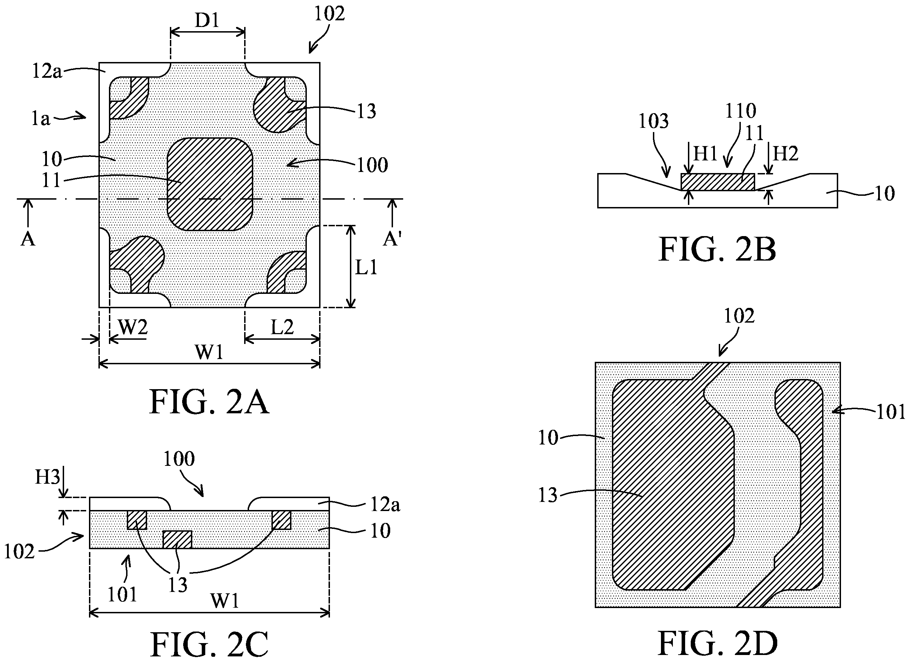

Referring to FIG. 1, which is a schematic diagram of the package structure at the formation stage of some embodiments of the disclosure. As shown in FIG. 1, in some embodiments, a plurality of lead frame components la that are connected to each other are provided. In some embodiments, these lead frame components 1a may be similar or the same, but the disclosure is not limited thereto. It should be noted that, for ease of understanding, some components in the lead frame component 1a are omitted in FIG. 1, and these components will be described in detail in FIGS. 2A to 2D.

FIGS. 2A to 2D respectively are a top view, a cross-sectional view along the line A-A' of FIG. 2A, a side view, and a bottom view of the lead frame component of some embodiments of the disclosure. As shown in FIGS. 2A to 2D, each lead frame component 1a includes a lead frame 10, and the lead frame 10 has an upper surface 100, a lower surface 101, and a side surface 102 between the upper surface 100 and the lower surface 101. Specifically, the lead frame 10 is used to carry electronic components thereon, such as a light-emitting diode 16, and an encapsulant 2, which will be described later.

In some embodiments, the lead frame 10 may be a plate lead frame, and the upper surface 100 and the lower surface 101 of which are substantially parallel. In some embodiments, the lead frame 10 is a rectangular lead frame with four side surfaces 102, but the disclosure is not limited thereto. In other embodiments, the lead frame 10 may also be a triangular lead frame with three side surfaces 102, a pentagonal lead frame with five side surfaces 102, a polygonal lead frame with more side surfaces 102, a circular lead frame with a ring-shaped side, or a lead frame with other shapes, but the disclosure is not limited thereto.

In some embodiments, the lead frame 10 may be made of or include polymer materials or other suitable materials, but the disclosure is not limited thereto. Examples of polymer materials include epoxy resin, polyimide (PI), polypropylene (PP), combinations thereof, and other suitable polymer materials, but the disclosure is not limited thereto.

As shown in FIGS. 2A and 2B, in some embodiments, the lead frame component 1a further includes a first connecting piece 11, and the first connecting piece 11 is at the center of the upper surface 100 of the lead frame 10. Specifically, the first connecting piece 11 is used to carry and fix the light-emitting diode 16, so the first connecting piece 11 may also be called a die bonding piece or a die bonding area. In some embodiments, the first connecting piece 11 may be made of or include conductive materials. The conductive materials may include metal, metal compounds, combinations thereof, or other suitable conductive materials, but the disclosure is not limited thereto. For example, the metal may be tin (Sn), copper (Cu), gold (Au), silver (Ag), nickel (Ni), indium (In), platinum (Pt), palladium (Pd), iridium (Ir)), titanium (Ti), chromium (Cr), tungsten (W), aluminum (Al), molybdenum (Mo), titanium (Ti), magnesium (Mg), zinc (Zn), germanium (Ge), or their alloys, but the disclosure is not limited thereto. For example, the metal compound may be tantalum nitride (TaN), titanium nitride (TiN), tungsten silicide (WSi2), indium tin oxide (ITO), antimony zinc oxide (AZO), tin oxide (SnO), zinc oxide (ZnO), indium zinc oxide (IZO), indium gallium zinc oxide (IGZO), indium tin zinc oxide (ITZO), antimony tin oxide (ATO), etc., but the disclosure is not limited thereto.

As shown in FIG. 2B, in some embodiments, the lead frame 10 has a recess 103, and the recess 103 surrounds the first connecting piece 11. Specifically, the recess 103 may be used as a buffer space (or an accommodating space) during the subsequent glue-filling process to prevent the glue from overflowing onto the upper surface 110 of the first connecting piece 11 during glue-filling, causing the area of upper surface 110 of the first connecting piece 11 is reduced. In some embodiments, the upper surface 110 of the first connecting piece 11 is at the same height as the periphery of the lead frame 10. In other words, the height H1 of the first connecting piece 11 may be similar to or the same as the height H2 (or depth) of the recess 103 of the lead frame 10, but the disclosure is not limited thereto.

As shown in FIGS. 2A and 2C, in some embodiments, the lead frame component 1a further includes an engaging protrusion 12a. The lead frame 10 has a corner, and the engaging protrusion 12a is on the corner of the lead frame 10 and extends along the adjacent two sides of the lead frame 10. Specifically, the engaging protrusion 12a protrudes from the lead frame 10 along the periphery of the lead frame 10, and the engaging protrusion 12a is used to engage with the encapsulant 2 provided subsequently. In this way, there may be a larger contact area between the lead frame component 1a and the encapsulant 2, thereby improving the shear strength of the entire package structure.

In the embodiments shown in FIGS. 2A and 2B, the engaging protrusions 12a are at the four corners of the lead frame 10, but the disclosure is not limited thereto. In other embodiments, the engaging protrusions 12a may also be on any two corners or any three corners of the lead frame 10. In some embodiments, the single engaging protrusion 12a may have a first length L1 on one side of the lead frame 10, and may have a second length L2 on the other side of the lead frame 10, wherein the first length L1 may be similar to or the same as the second length L2, but the disclosure is not limited thereto. In some embodiments, the first length L1 or the second length L2 may be 10%, 20%, 30%, 40%, 50%, or any value or any range between the above values of the side length (or width W1) of the lead frame 10, but the disclosure is not limited thereto. In some embodiments, there may be a distance D1 between two adjacent engaging protrusions 12a, and the four distances D1 between the four engaging protrusions 12a may be similar to or the same as each other, but the disclosure is not limited thereto.

In some embodiments, the first length L1, the second length L2, the width W2, and the height H3 of the engaging protrusion 12a are all greater than 0.1 mm. For example, any one of the first length L1, the second length L2, the width W2, and the height H3 of the engaging protrusion 12a may be 0.15 mm, 0.20 mm, 0.25 mm, 0.30 mm, or 0.35 mm, 0.40 mm, 0.50 mm, 0.60 mm, 1.00 mm, or any value or any range between the above values, but the disclosure is not limited thereto. In some embodiments, the engaging protrusion 12a may include the above polymer materials or other suitable materials, but the disclosure is not limited thereto. In some embodiments, the material of the engaging protrusion 12a may be the same as or different from the material of the lead frame 10, but the disclosure is not limited thereto. In some embodiments, the engaging protrusion 12a may be integrally formed with the lead frame 10 in the same process, but the disclosure is not limited thereto. In other embodiments, the lead frame 10 may be formed first, and then the engaging protrusion 12a may be formed on the lead frame 10.

As shown in FIGS. 2A, 2C and 2D, in some embodiments, the lead frame component 1a further includes a supporting piece 13, and the supporting piece 13 is disposed in the lead frame 10. Specifically, the supporting piece 13 is used to enhance the mechanical strength of the lead frame 10 to ensure that the lead frame 10 will not be mechanically deformed before, during, or after the cutting process. In some embodiments, the mechanical strength of the supporting piece 13 is higher than that of the lead frame 10.

As shown in FIG. 1, the supporting piece 13 is disposed in the lead frame 10 and extends through the plurality of lead frames 10. Among them, the supporting piece 13 is used to ensure that the lead frame 10 has sufficient mechanical strength and is used to connect two adjacent lead frames 10. In subsequent processes, a cutting process may be performed on the plurality of lead frame components 1a along a slicing line SL to separate the plurality of lead frames 10 from each other in the horizontal direction. After the cutting process, the supporting piece 13 will be exposed from the side surface 102 (the side surface exposed after cutting) of the lead frame 10.

In some existing package structures, the supporting piece 13 is usually on the side of the lead frame 10 adjacent to the lower surface 101 and is exposed from the lower surface 101 of the lead frame 10. The exposed supporting piece 13 has metal burrs caused by the cutting process. The lower surface 101 of the lead frame 10 may be connected to a substrate component such as a circuit board. If the lower surface 101 of the lead frame 10 exposes the supporting piece 13 that has a lot of metal burr, it may cause the lead frame 10 to be unable to fit closely with the substrate below it. Therefore, in the case that the total volume of the supporting piece 13 remains unchanged, a part of the supporting piece 13 may be disposed on the side of the lead frame 10 adjacent to the upper surface 100 (as shown in FIG. 2C) to reduce the area of the supporting piece 13 exposed from the lower surface 101. In this way, affecting the stability of the connection between the package structure and other devices due to metal burrs may be prevented.

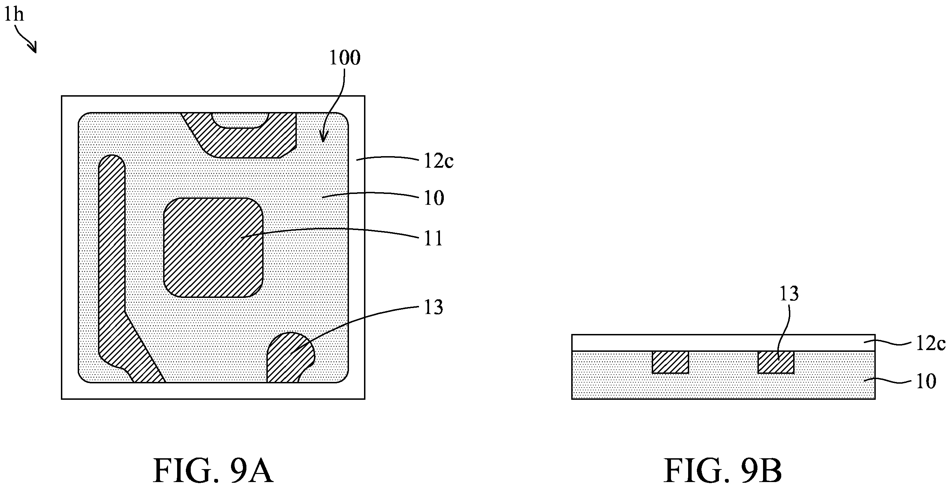

It should be noted that although the embodiment describes that the supporting piece 13 may be disposed on both the upper surface 100 and the lower surface 101 of the lead frame 10, the disclosure is not limited thereto. In other embodiments, the entire supporting piece 13 may also be disposed on the upper surface 100 of the lead frame 10 (as shown in FIG. 9B to be described later) if it is practicable for the manufacturing process so as to completely prevent the metal burrs from affecting the stability of the connection between the package structure and other devices.

Hereinbefore, the lead frame component 1a for carrying the light-emitting diode 16 and the encapsulating 2 thereon has been provided of some embodiments of the disclosure, wherein the lead frame component 1a includes the lead frame 10, the first connecting piece 11, the engaging protrusion 12a, and the supporting piece 13. Next, other aspects of the lead frame component will be provided of other embodiments of the disclosure.

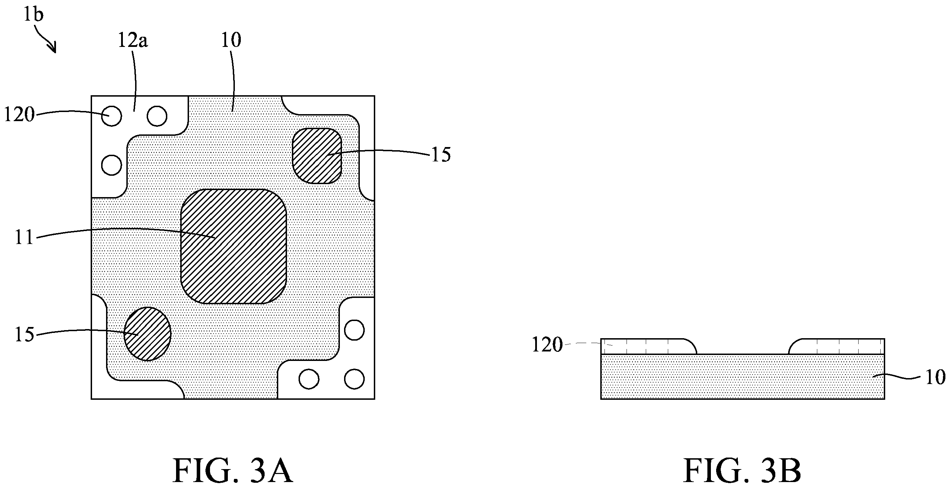

FIGS. 3A and 3B respectively are a top view and a side view of the lead frame component of other embodiments of the disclosure. Compared with the embodiments shown in FIGS. 2A to 2D, the engaging protrusion 12a in a lead frame component 1b of these embodiments in FIGS. 3A and 3B has a first through hole 120, and the first through hole 120 penetrates the engaging protrusion 12a. Specifically, the first through hole 120 is used to accommodate the encapsulant 2 to further increase the contact surface area between the lead frame component 1b and the encapsulant 2 provided subsequently. In some embodiments, there may be a plurality of first through holes 120, and they are disposed in sequence on the upper surface of the engaging protrusion 12a. It should be noted that although FIG. 3A illustrates three circular first through holes 120, the disclosure is not limited thereto. In some embodiments, there may be one, two, four, or more first through holes 120. In some embodiments, the first through hole 120 may be a circular through hole, a triangular through hole, a rectangular through hole, a polygonal through hole, a special-shaped through hole, or a through hole with other shapes. In some embodiments, the size, the shape, and the spacing between the plurality of first through holes 120 may be similar or the same, but the disclosure is not limited thereto.

In addition, the lead frame component 1b of these embodiments in FIGS. 3A and 3B further includes a second connecting piece 15. In some embodiments, the second connecting piece 15 is disposed on the upper surface 100, and the second connecting piece 15 is between the engaging protrusion 12a and the first connecting piece 11. Specifically, the second connecting piece 15 is used to electrically connect the light-emitting diode 16. The second connecting piece 15 may be made of or include an electrical connecting piece (e.g., a pad) for providing a data signal, a selection signal, a power voltage, or a ground voltage, but the disclosure is not limited thereto. In some embodiments, the material of the second connecting piece 15 may be similar to or the same as the material of the first connecting piece 11, but the disclosure is not limited thereto. In some embodiments, the second connecting piece 15 may be integrally formed with the first connecting piece 11 in the same manufacturing process, but the disclosure is not limited thereto. In other embodiments, the first connecting piece 11 may be formed first, and then the second connecting piece 15 may be formed.

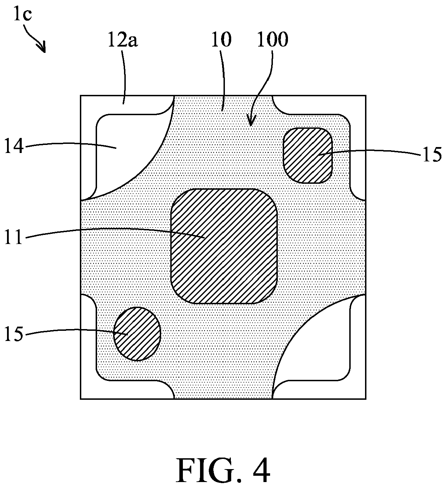

FIG. 4 is a top view of the lead frame component of other embodiments of the disclosure. Compared with the embodiments shown in FIG. 3A, a lead frame component 1c of these embodiments in FIG. 4 further includes a step portion 14. The step portion 14 is between the engaging protrusion 12a and the lead frame 10, and the step portion 14 is used to increase the contact surface area between the lead frame component 1b and the subsequent encapsulant 2. In the plan view of FIG. 4, the area of the step portion 14 is larger than the area of the engaging protrusion 12a. For example, the area of the step portion 14 may be 2 times, 3 times, 4 times, or more times the area of the engaging protrusion 12a, but the disclosure is not limited thereto. In some embodiments, the step portions 14 are disposed on two opposite corners of the lead frame 10, but the disclosure is not limited thereto. In some embodiments, the material of the step portion 14 may be similar to or the same as the material of the engaging protrusion 12a, but the disclosure is not limited thereto. In some embodiments, the step portion 14 and the engaging protrusion 12a may be integrally formed in the same process, but the disclosure is not limited thereto. In other embodiments, the step portion 14 may be formed first, and then the engaging protrusion 12a is formed on the step portion 14.

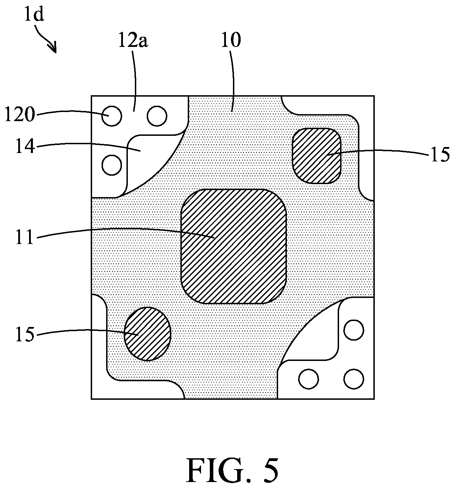

FIG. 5 is a top view of the lead frame component of other embodiments of the disclosure. Compared with the embodiments shown in FIG. 4, the engaging protrusion 12a in a lead frame component 1d of these embodiments of FIG. 5 has the first through hole 120, and the first through hole 120 penetrates the engaging protrusion 12a. By providing through holes in the engaging protrusion 12a and providing the step portion 14 at the same time, the contact surface area between the lead frame component 1d and the encapsulant 2 provided subsequently may be greatly increased.

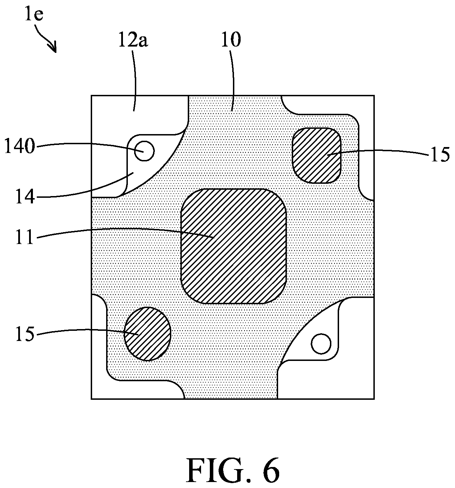

FIG. 6 is a top view of the lead frame component of other embodiments of the disclosure. Compared with the embodiments shown in FIG. 4, the step portion 14 in a lead frame component 1e of these embodiments of FIG. 6 has a second through hole 140, and the second through hole 140 penetrates the step portion 14. Specifically, the second through hole 140 is used to accommodate the encapsulant 2 to further increase the contact surface area between the lead frame component 1e and the encapsulant 2 provided subsequently. In some embodiments, there may be the plurality of second through holes 140, which are disposed in sequence on the upper surface of the step portion 14. It should be noted that although FIG. 6 illustrates that one second through hole 140 has a circular shape, the disclosure is not limited thereto. In some embodiments, there may be two, three, four, or more second through holes 140. In some embodiments, the second through hole 140 may be a circular through hole, a triangular through hole, a rectangular through hole, a polygonal through hole, a special-shaped through hole, or a through hole with other shapes. In some embodiments, the size, the shape, and the spacing between the plurality of second through holes 140 may be similar or the same, but the disclosure is not limited thereto.

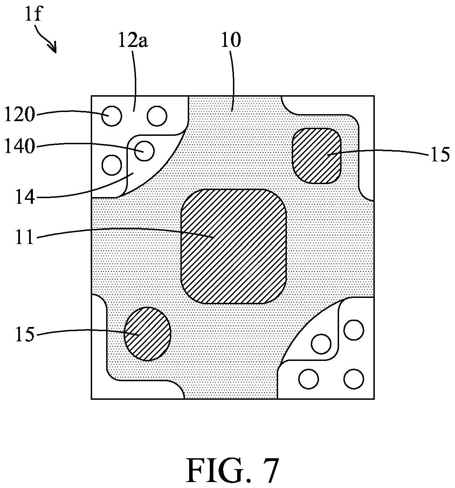

FIG. 7 is a top view of the lead frame component of other embodiments of the disclosure. In these embodiments, the engaging protrusion 12a has the first through hole 120, and the step portion 14 has the second through hole 140. By simultaneously providing the through holes in the engaging protrusion 12a and in the step portion 14, the contact surface area between the lead frame component 1f and the encapsulant 2 provided subsequently may be greatly increased. In some embodiments, the number, the shape, and the size of the first through holes 120 may be the same as or different from the second through holes 140, but the disclosure is not limited thereto.

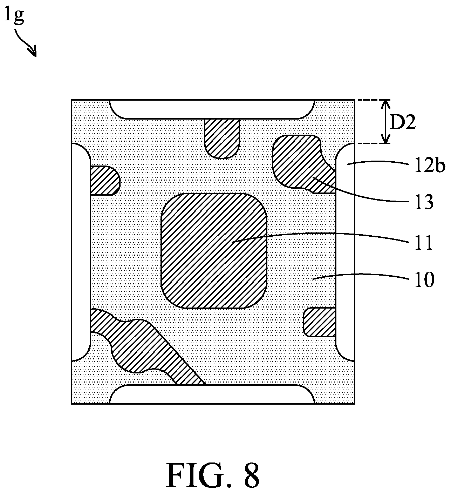

FIG. 8 is a top view of the lead frame component of other embodiments of the disclosure. Compared with the embodiments shown in FIGS. 2A to 2D, a lead frame component 1g of these embodiments in FIG. 8 has a side, and an engaging protrusion 12b is on the side (instead of the corner) and extends toward the corner of the lead frame 10. In these embodiments shown in FIG. 8, the engaging protrusion 12b is on four sides of the lead frame 10, but the disclosure is not limited thereto. In other embodiments, the engaging protrusions 12b may also be on any two sides or any three sides of the lead frame 10. In some embodiments, the plurality of engaging protrusions 12b may have the same length, but the disclosure is not limited thereto. In some embodiments, the engaging protrusion 12b and the corner of the lead frame 10 may have a distance D2, and the distance D2 may be 10%, 20%, 30%, 40%, 50%, or any value or any range between the above values of the side length (or width W1) of the lead frame 10, but the disclosure is not limited thereto. It should be noted that, although not shown in the figures, the plurality of engaging protrusions 12b may have different heights.

FIGS. 9A and. 9B respectively are a top view and a side view of the lead frame component of other embodiments of the disclosure. Compared with the embodiments shown in FIGS. 2A to 2D, an engaging protrusion 12c in a lead frame component 1h of these embodiments in FIGS. 9A and 9B is disposed around the upper surface 100 of the lead frame 10. In some embodiments, the engaging protrusion 12c may have one or more first through holes (not shown). Alternatively, the engaging protrusions 12c may have multiple heights. For example, the engaging protrusion 12c may be wavy or stepped in a side view. As shown in FIG. 9B, in some embodiments, the supporting piece 13 in the lead frame component 1h may be entirely disposed on the upper surface 100 of the lead frame 10 to completely prevent the metal burrs of the supporting piece 13 from affecting the connection stability between the package structure and other devices.

Obviously, although various aspects of the lead frame components (e.g., lead frame components 1a to 1h) are provided above of some embodiments of the disclosure, the disclosure is not limited thereto. A person having ordinary skill in the art may arbitrarily adopt some of the specific configurations mentioned above, or modify the specific configurations to significantly increase the contact surface area between the lead frame component and the encapsulant provided subsequently.

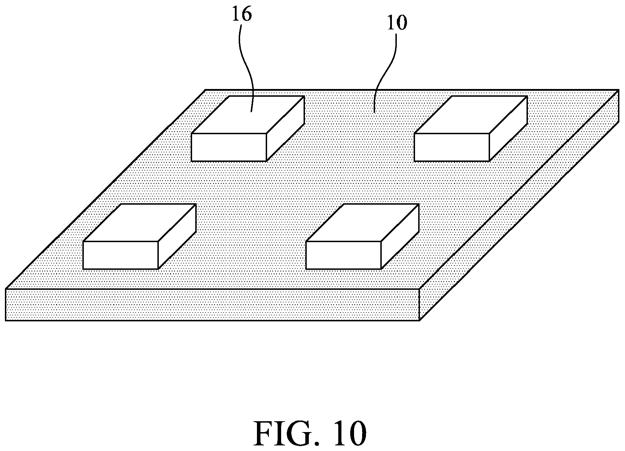

FIG. 10 is a schematic diagram of the package structure at one formation stage of some embodiments of the disclosure. Continuing the process of FIG. 1, the light-emitting diode 16 is disposed on the lead frame 10 in the lead frame component 1a (or any one of the lead frame components 1b to 1h), and the light-emitting diode 16 is fixed on the first connecting piece 11. For example, the light-emitting diode 16 may be fixed on the first connecting piece 11 through a die-bonding process or other suitable processes, but the disclosure is not limited thereto. In some embodiments, the light-emitting diode 16 may be a blue LED, an ultraviolet LED, a combination thereof, or other suitable LEDs.

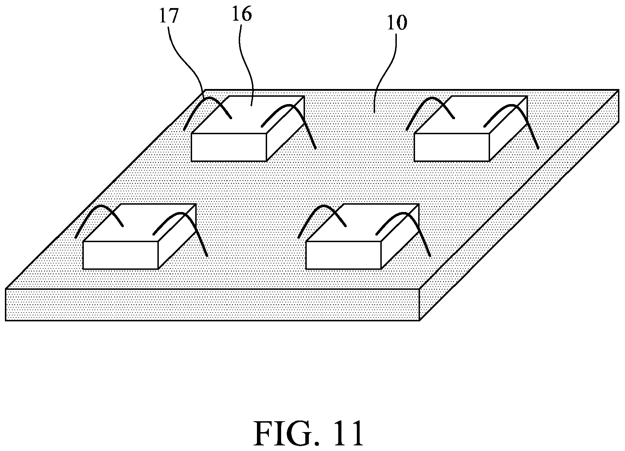

FIG. 11 is a schematic diagram of the package structure at one formation stage of some embodiments of the disclosure. Continuing the process of FIG. 10, a connecting wire 17 is disposed between the lead frame 10 and the light-emitting diode 16 so that the light-emitting diode 16 and the lead frame 10 are electrically connected through the connecting wire 17. For example, the connecting wire 17 may be provided through a wire-bonding process or other suitable processes, but the disclosure is not limited thereto. In some embodiments, one end of the connecting wire 17 may be electrically connected to the electrode of the light-emitting diode 16, and the other end may be electrically connected to the second connecting piece 15 on the lead frame 10, but the disclosure is not limited thereto. In some embodiments, the light-emitting diode 16 is a flip-chip light-emitting diode, and the flip-chip light-emitting diode 16 is electrically connected to the lead frame 10.

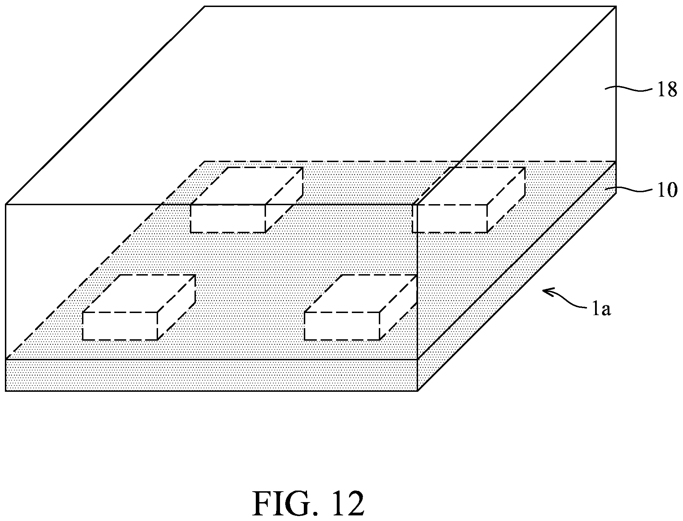

FIG. 12 is a schematic diagram of the package structure at one formation stage of some embodiments of the disclosure. Continuing the process of FIG. 11, the fluorescent encapsulant 18 is disposed on the lead frame component 1a (or any one of the lead frame components 1b to 1h), and a fluorescent encapsulant 18 covers the light-emitting diode 16 and the engaging protrusion 12a (or the engaging protrusion 12b, the engaging protrusion 12c). For example, the fluorescent encapsulant 18 may be disposed through a compression molding process or other suitable processes, but the disclosure is not limited thereto.

In some embodiments, the fluorescent encapsulant 18 may include red light conversion materials, blue light conversion materials, green light conversion materials, yellow light conversion materials, other suitable light conversion materials, or combinations thereof. In some embodiments, the red light conversion material may be red quantum dots or red phosphor, but the disclosure is not limited thereto. For example, the red light conversion material may be (Sr,Ca)AlSiN₃:Eu²⁺, Ca₂SisN₈:Eu²⁺, Sr(LiAl₃N₄):Eu²⁺, manganese-doped red fluoride phosphors, combinations thereof, or the like, but the disclosure is not limited thereto. The manganese-doped red fluoride phosphor may be K₂GeF₆:Mn⁴⁺, K₂SiF₆:Mn⁴⁺, K₂TiF₆:Mn⁴⁺, combinations thereof, or the like, but the disclosure is not limited thereto. In some embodiments, the blue light conversion material may be blue quantum dots or blue phosphor, but the disclosure is not limited thereto. In some embodiments, the green light conversion material may be green quantum dots or green phosphor, but the disclosure is not limited thereto. For example, the green light conversion material may be LuAG phosphor, YAG phosphor, β-SiAlON phosphor, or silicate phosphor, combinations thereof, or the like, but the disclosure is not limited thereto. In some embodiments, the yellow light conversion material may be yellow quantum dots or yellow phosphor. For example, the yellow light conversion material may be yttrium aluminum garnet (YAG) phosphor. In some embodiments, the light-emitting diode 16 may be a blue LED, and the fluorescent encapsulant 18 may include a yellow light conversion material, or the fluorescent encapsulant 18 may include a combination of green light conversion material and red light conversion material. For example, the fluorescent encapsulant 18 may include green Sialon phosphor and red K₂SiF₆:Mn⁴⁺. In some embodiments, the fluorescent encapsulant 18 may include a green light conversion material and a combination of two red light conversion materials. For example, the fluorescent encapsulant 18 may include green Sialon phosphor, red K₂SiF₆:Mn⁴⁺ and red (Sr, Ca)AlSiN₃:Eu²⁺.

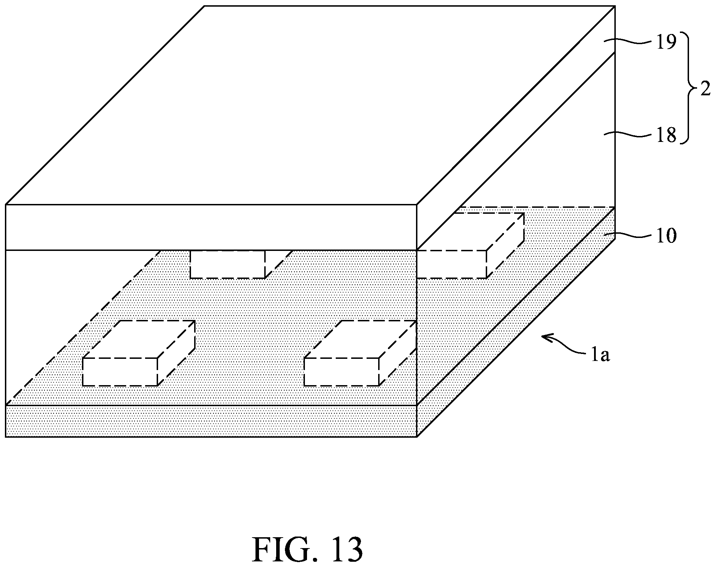

FIG. 13 is a schematic diagram of the package structure at one formation stage of some embodiments of the disclosure. Continuing the process of FIG. 12, in some embodiments, a white encapsulant 19 is disposed on the fluorescent encapsulant 18. For example, the white encapsulant 19 may be provided through a compression molding process or other suitable processes, but the disclosure is not limited thereto. In some embodiments, the white encapsulant 19 may be made of or include a white reflective material (such as white paint or other white materials), a white photoresist material, a combination thereof, or other suitable white materials, but the disclosure is not limited thereto. In some embodiments, the fluorescent encapsulant 18 and the white encapsulant 19 are collectively referred to as the encapsulant 2. In some embodiments, the lead frame component 1a (or any one of the lead frame components 1b to 1h), the light-emitting diode 16 (and the connecting wire 17), and the encapsulant 2 are collectively referred to as the package structure 3.

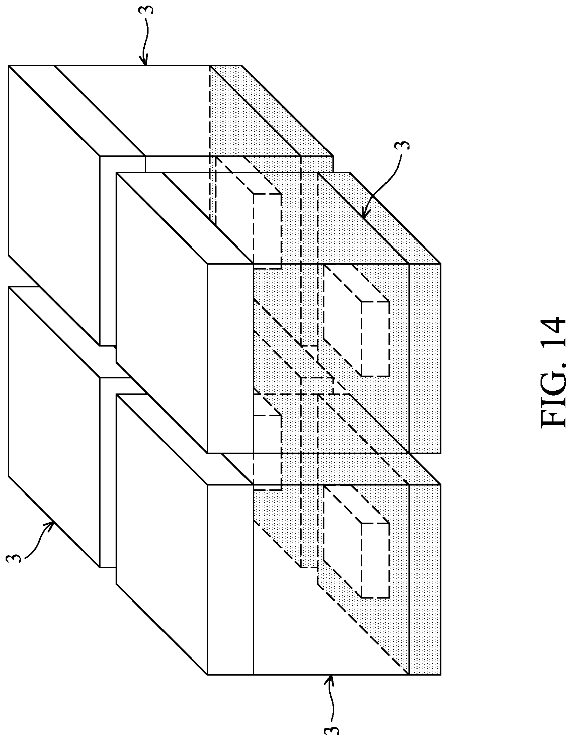

FIG. 14 is a schematic diagram of the package structure at one formation stage of some embodiments of the disclosure. Continuing the process of FIG. 13, in some embodiments, the plurality of package structures 3 connected to each other are divided into the plurality of package structures 3 that are independent of each other. For example, a baking process may be performed on the plurality of package structures 3 first, and then a cutting process may be performed on the plurality of package structures 3 connected to each other in FIG. 12 along, for example, the slicing line SL shown in FIG. 1, to form the plurality of the package structures 3 that are independent of each other, but the disclosure is not limited thereto. In some embodiments, the side surface 102 of the lead frame 10 and the side surface of the supporting piece 13 exposed through cutting are coplanar. In some embodiments, the side surfaces of the white encapsulant 19, the side surfaces of the fluorescent encapsulant 18, the side surfaces 102 of the lead frame 10, and the side surfaces of the supporting piece 13 exposed through cutting are coplanar.

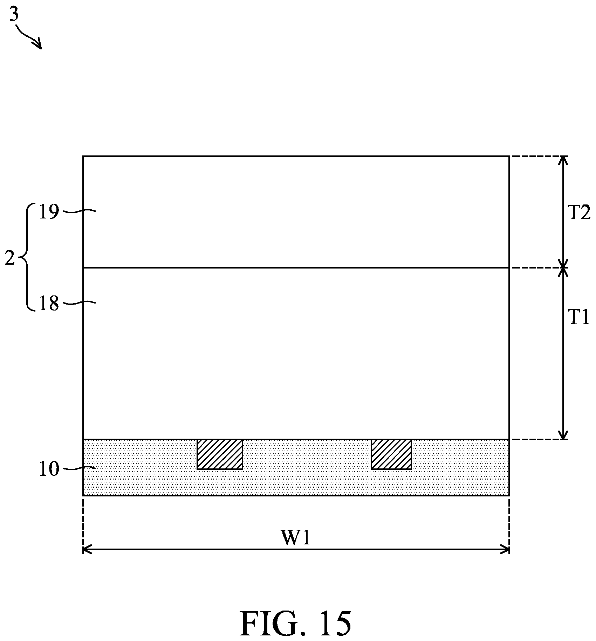

FIG. 15 is a schematic side view of the package structure of some embodiments of the disclosure. As shown in FIG. 15, the lead frame 10 in each package structure 3 has a width W1, the fluorescent encapsulant 18 in the encapsulant 2 has a first thickness T1, and the white encapsulant 19 has a second thickness T2. In some embodiments, the sum of the first thickness T1 and the second thickness T2 is less than or equal to the width W1. For example, the sum of the first thickness T1 and the second thickness T2 may be 60%, 70%, 80%, 90%, 95%, or 100% of the width W1, but the disclosure is not limited thereto. In the case that the sum of the first thickness T1 and the second thickness T2 does not exceed the width W1, the luminous brightness of the package structure 3 may be effectively improved by thickening the first thickness T1 of the fluorescent encapsulant 18. In some embodiments, a ratio of the first thickness T1 to the second thickness T2 is between 3 and 18. For example, the ratio of the first thickness T1 to the second thickness T2 may be 3, 5, 7, 9, 11, 13, 15, 18, or any value or any range between the above values, but the disclosure is not limited thereto.

As mentioned above, the service life of the package structure 3 may be effectively ensured by disposing the engaging protrusion 12a (or the engaging protrusions 12b-12c) and controlling the ratio between the sum of the first thickness T1 and the second thickness T2 and the width W1 (i.e., (T2+T1)/W1). Compared with the package structure without the engaging protrusion 12a (or the engaging protrusion 12b or the engaging protrusion 12c), it takes at least 101% to 130% of the thrust force to separate the encapsulant 2 from the lead frame component 1 of the package structure 3 of the disclosure. In addition, the disclosure further improves the luminous intensity of the package structure 3 by controlling the ratio between the first thickness T1 and the second thickness T2.

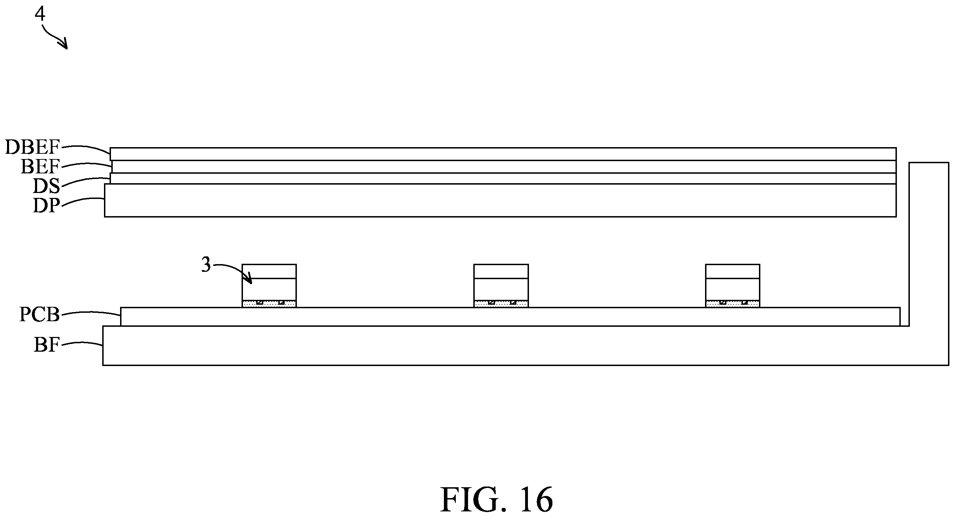

FIG. 16 is a schematic diagram of the backlight module of some embodiments of the disclosure. In some embodiments, the package structure 3 of the disclosure may be applied in a backlight module 4 and serve as a light-emitting unit. As shown in FIG. 16, the backlight module 4 may include the dual brightness enhancement film DBEF, the brightness enhancement film BEF, the diffuser film DS, the diffuser plate DP, the package structure 3, the printed circuit board PCB, and the bottom frame BF. Among them, the package structure 3 may be electrically connected to the printed circuit board PCB and emit light toward the upper optical layer (for example, the double brightness enhancement film DBEF, the brightness enhancement film BEF, the diffusion film DS, and the diffusion plate DP). It should be noted that although FIG. 16 shows a possible structure and configuration of the backlight module 4, the disclosure is not limited thereto. In other embodiments, the package structure 3 of the disclosure may also be applied to various backlight modules that are well known to a person having ordinary skill in the art.

The foregoing outlines features of several embodiments of the disclosure, so that a person of ordinary skill in the art may better understand the aspects of the disclosure. A person of ordinary skill in the art should appreciate that, the disclosure may be readily used as a basis for designing or modifying other processes and structures for carrying out the same purposes and/or achieving the same advantages of the embodiments introduced herein. A person of ordinary skill in the art should also realize that such equivalent constructions do not depart from the scope of the disclosure, and that they may make various changes, substitutions, and alterations herein without departing from the scope of the disclosure.

## Claims

1. A package structure, comprising:
a lead frame (10) having an upper surface (100), a lower surface (101), and a side surface (102), wherein the side surface (102) is between the upper surface (100) and the lower surface (101);
a first connecting piece (11) disposed at a center of the upper surface (100);
a light-emitting diode (16) disposed on the first connecting piece (11);
an engaging protrusion (12a) disposed on a periphery of the upper surface (100); and
a fluorescent encapsulant (2) disposed on the upper surface (100) and covering the light-emitting diode (16) and the engaging protrusion (12a).

2. The package structure as claimed in claim 1, wherein the lead frame (10) has a corner, and the engaging protrusion (12a) is on the corner of the lead frame (10) and extends along two adjacent sides of the lead frame (10).

3. The package structure as claimed in claim 1 or 2, further comprising a step portion (14), wherein the step portion (14) is between the engaging protrusion (12a) and the lead frame (10), preferably in a plan view, an area of the step portion (14) is larger than an area of the engaging protrusion (12a).

4. The package structure as claimed in claim 1, 2 or 3, wherein the engaging protrusion (12a) has a first through hole (120), and a part of the fluorescent encapsulant (2) is in the first through hole (120).

5. The package structure as claimed in claim 1, 2, 3 or 4, wherein the step portion (14) has a second through hole (140), and a part of the fluorescent encapsulant (2) is in the second through hole (140).

6. The package structure as claimed in claim 1, 2 or 3, wherein the engaging protrusion (12a) has a first through hole (120), the step portion (14) has a second through hole (140), and a part of the fluorescent encapsulant (2) is in the first through hole (120) and the second through hole (140).

7. The package structure as claimed in any one of the preceding claims, wherein the lead frame (10) has one side, and the engaging protrusion (12a) is on the side of the lead frame (10) and extends toward a corner of the lead frame (10).

8. The package structure as claimed in any one of the preceding claims, wherein the engaging protrusion (12a) is disposed around the lead frame (10).

9. The package structure as claimed in any one of the preceding claims wherein a material of the engaging protrusion (12a) is different from a material of the lead frame (10) and/or the engaging protrusion (12a) is wavy or stepped in a side view.

10. The package structure as claimed in any one of the preceding claims, wherein a length, a width, or a height of the engaging protrusion (12a) is greater than 0.1mm.

11. The package structure as claimed in any one of the preceding claims, wherein the light-emitting diode (16) is a blue LED, and the fluorescent encapsulant (2) comprises yellow light conversion materials and/or further comprising a white encapsulant (19) disposed on the fluorescent encapsulant (2).

12. The package structure as claimed in any one of the preceding claims, wherein the lead frame (10) has a width (W1), the fluorescent encapsulant (2) has a first thickness (T1), the white encapsulant (19) has a second thickness (T2), and the sum of the first thickness (T1) and the second thickness (T2) is less than or equal to the width (W1).

13. The package structure as claimed in any one of the preceding claims, wherein the fluorescent encapsulant (2) has a first thickness (T1), the white encapsulant (19) has a second thickness (T2), and a ratio of the first thickness (T1) to the second thickness (T2) is between 3 and 18.

14. The package structure as claimed in any one of the preceding claims, further comprising a second connecting piece (15) disposed on the upper surface (100), and the second connecting piece (15) is between the engaging protrusion (12a) and the first connecting piece (11).

15. The package structure as claimed in any one of the preceding claims, further comprising a supporting piece (13) disposed in the lead frame (10), wherein a mechanical strength of the supporting piece (13) is higher than a mechanical strength of the lead frame (10), preferably at least a part of the supporting piece (13) is on a side of the lead frame (10) adjacent to the upper surface (100) and/or preferably the entire supporting piece (13) is on the side of the lead frame (10) adjacent to the upper surface (100).
